(19) Europäisches Patentamt
European Patent Office
Office européen des brevets

(11) **EP 4 187 263 B1**

(12) **EUROPÄISCHE PATENTSCHRIFT**

(45) Veröffentlichungstag und Bekanntmachung des Hinweises auf die Patenterteilung:
**16.04.2025   Patentblatt 2025/16**

(21) Anmeldenummer: **22209158.9**

(22) Anmeldetag: **23.11.2022**

(51) Internationale Patentklassifikation (IPC):
**G01R 19/25** (2006.01)      **G01R 25/00** (2006.01)

(52) Gemeinsame Patentklassifikation (CPC):
**G01R 25/00; G01R 19/25**

(54) **VERFAHREN ZUR PHASORBESTIMMUNG EINES STROM- ODER SPANNUNGSSIGNALS**

METHOD FOR DETERMINING THE PHASOR OF A CURRENT OR VOLTAGE SIGNAL

PROCÉDÉ DE DÉTERMINATION DE PHASE D'UN SIGNAL DE COURANT OU DE TENSION

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität:   **24.11.2021   AT 509402021**

(43) Veröffentlichungstag der Anmeldung:
**31.05.2023   Patentblatt 2023/22**

(73) Patentinhaber: **Sprecher Automation GmbH**
**4020 Linz (AT)**

(72) Erfinder: **Sult, Tilmann**
**12527 Berlin (DE)**

(74) Vertreter: **Hübscher & Partner Patentanwälte GmbH**
**Spittelwiese 4**
**4020 Linz (AT)**

(56) Entgegenhaltungen:
- **ANDREW J ROSCOE ET AL: "P-Class Phasor Measurement Unit algorithms using adaptive filtering to enhance accuracy at off-nominal frequencies", SMART MEASUREMENTS FOR FUTURE GRIDS (SMFG), 2011 IEEE INTERNATIONAL CONFERENCE ON, IEEE, 14 November 2011 (2011-11-14), pages 51 - 58, XP032090422, ISBN: 978-1-4577-1313-2, DOI: 10.1109/SMFG.2011.6125761**
- **RECIOUI ABDELMADJID ET AL: "Design of an IIR digital filter for phasor measurement improvement based on a hybrid optimization algorithm", 2013 3RD INTERNATIONAL CONFERENCE ON ELECTRIC POWER AND ENERGY CONVERSION SYSTEMS, IEEE, 2 October 2013 (2013-10-02), pages 1 - 6, XP032550815, DOI: 10.1109/ EPECS.2013.6713004**

**Beschreibung**

Die Erfindung bezieht sich auf ein Verfahren zur Phasorbestimmung eines Strom- oder Spannungssignals wobei das Strom- oder Spannungssignal abgetastet wird und die zeitlich diskreten Abtastwerte einer mehrstufigen Filterkaskade zugeführt werden, wonach aus den in den Frequenzbereich transformierten, gefilterten Abtastwerten die Parameter des Phasors bestimmt und ausgegeben werden.

Aus dem Stand der Technik sind Verfahren zur Phasorbestimmung eines Strom- oder Spannungssignals bekannt, bei dem das abgetastete zeitdiskrete Signal eines kapazitiven Spannungswandlers (CVT) mittels eines numerischen Algorithmus vorgefiltert wird, bevor es einer Fourier-Transformation zugeführt wird. Der benützte Filter mit endlicher Impulsantwort setzt sich aus zwei kaskadierten Filterstufen zusammen, wobei eine Filterstufe abklingende Gleich- und Wechselstromanteile ausfiltert, die kleiner als die definierte Netzfrequenz von 50 oder 60Hz sind. Die zweite Filterstufe bildet einen dynamischen Speicher, der bestimmte Samples speichert, aus diesen einen Durchschnittswert bildet und mit diesem Durchschnittswert den Ausgangswert des Filters zusammenstellt.

ANDREW J ROSCOE ET AL: "P-Class Phasor Measurement Unit algorithms using adaptive filtering to enhance accuracy at off-nominal frequencies",SMART MEASUREMENTS FOR FUTURE GRIDS (SMFG), 2011 IEEE INTERNATIONAL CONFERENCE ON, IEEE, 14. November 2011 (2011-11-14), Seiten 51-58, DOI: 10.1109/SMFG.2011.6125761ISBN: 978-1-4577-1313-2 offenbart ein Verfahren zur Phasorbestimmung eines Strom- der Spannungssignals, wobei das Strom- oder Spannungssignal abgetastet wird und die zeitlich diskreten Abtastwerte einer mehrstufigen Filterkaskade zugeführt werden, wonach aus den in den Frequenzbereich transformierten, gefilterten Abtastwerten die Parameter des Phasors bestimmt und ausgegeben werden.

Nachteilig am Stand der Technik ist allerdings, dass die Filterung unerwünschte Signalanteile nur unterhalb einer statischen, vordefinierten Frequenz ausfiltern kann, unabhängig davon, wie stark die entsprechenden Signalanteile die Phasorenbestimmung stören. Darüber hinaus gehen insbesondere beim Absinken der Netzfrequenz möglicherweise Signalanteile verloren, die zur korrekten Bestimmung des Phasors benötigt werden, wodurch sich die Qualität des Ausgangswerts verschlechtert.

Der Erfindung liegt somit die Aufgabe zugrunde, selbst im Falle einer Frequenzänderung des Strom- oder Spannungssignals ein zuverlässiges und schnelles Bestimmen des Phasors zu ermöglichen.

Die Erfindung löst die gestellte Aufgabe dadurch, dass die Filterkaskade mehrere Filterstufen umfasst, wobei in jeder Filterstufe ein Signalanteil mit einem vorgegebenen Vielfachen einer in einem Frequenzspeicher abgespeicherten Grundfrequenz aus den Abtastwerten ausgefiltert und dazu aufeinanderfolgende Eingangswerte zur Bestimmung eines Ausgangswerts zwischengespeichert werden. Die Erfindung geht dabei von der Überlegung aus, dass sich für ein bestimmtes Stromnetz Signalanteile, die die Phasorbestimmung stören, an immer gleichen Frequenzen befinden, die Vielfachen der Grundfrequenz entsprechen. Die Harmonischen der Grundfrequenz lassen sich durch Multiplikation der Grundfrequenz mit einer natürlichen Zahl bestimmen. Durch das Ausfiltern dieser Signalanteile kann die Phasorbestimmung deutlich verbessert werden, ohne dass ganze Frequenzbereiche mit dem Nachteil ausgefiltert werden, dass möglichen Signaländerungen, insbesondere in Bezug auf die Signalfrequenz, nicht oder nur langsam gefolgt werden kann. Durch das Ausfiltern von Vielfachen der Grundfrequenz ist der herausgefilterte Frequenzbereich relativ zu der Grundfrequenz festgelegt und kann sich dadurch bei einer Frequenzänderung der Grundfrequenz mitändern. Ferner gibt es keine absolute Schranke, unter der Signalanteile herausgefiltert werden, da dies dazu führen könnte, dass bei einer Absenkung der Grundfrequenz die Filterkaskade eben die Signalanteile entfernt, aus denen in weiterer Folge der Phasor bestimmt werden soll. In einem optionalen weiteren Verfahrensschritt kann beispielsweise vor Beginn und/oder während des Verfahrens die Grundfrequenz und bevorzugt aus dieser die Vielfachen bestimmt und die Filter an diese angepasst werden. Die Grundfrequenz ist dabei immer die niedrigste Frequenz, die Vielfachen dieser Grundfrequenz berechnen sich aus der Grundfrequenz multipliziert mit einer positiven, reellen Zahl. Um die Phasorkomponenten zu bestimmen, kann beispielsweise folgendes Modell angewandt werden:

Die Eingangswerte können in folgender Form mathematisch beschrieben werden:

$$x_n = A\sin(n\Delta) + B\cos(n\Delta) + C\alpha^n$$

Dabei ist $\Delta = \frac{2\pi f}{f_s}$, f die Frequenz des Strom- oder Spannungssignals und $f_s$ die Frequenz mit der das Strom- oder Spannungssignal abgetastet wird und n der Index des jeweiligen Eingangswertes. Die ersten beiden Terme von $x_n$ beschreiben die Grundschwingung und der letzte Term ist ein exponentieller Störterm. Um die unbekannten, zur Phasorbestimmung notwendigen Komponenten A,B,C und $\alpha$ zu bestimmen wird zunächst folgende Cosinustransformation angewandt:

$$r_n = x_n - 2\cos(\Delta)\,x_{n-1} + x_{n-2}$$

In die die entsprechenden Eingangswerte $x_n$, $x_{n-1}$ und $x_{n-2}$ eingesetzt werden. Mittels den Sinus- und Cosinusadditionstheoremen lassen sich aus $r_n$ und $r_{n-1}$ Ausdrücke für $\alpha$ und C bestimmen, anschließend erhält man mit der ursprünglichen Gleichung für $x_n$ Ausdrücke zur Bestimmung von A und aus der Gleichung für $x_n$ und $x_{n-1}$ erhält man Ausdrücke zur Bestimmung von B. Um ausreichend Eingangswerte zur Bestimmung von A,B,C und $\alpha$ zu erhalten, können die Eingangswerte aufeinander folgender Zeitschritte für die Komponentenbestimmung verwendet werden. So können beispielsweise $\alpha$, A, B und C aus $r_1$ und $r_0$ bestimmt werden. Damit ergeben sich die folgenden Ausdrücke:

$$r_0 = x_0 - 2\cos(\Delta)x_{-1} + x_{-2}$$

$$r_1 = x_1 - 2\cos(\Delta)x_0 + x_{-1}$$

$$\alpha = \frac{r_1}{r_0}$$

$$C = \frac{r_1\alpha}{\alpha^2 - 2\alpha\cos(\Delta) + 1}$$

$$B = x_0 - C$$

$$A = \frac{x_1 - B\cos(\Delta) - C\alpha}{\sin(\Delta)}$$

Durch die Bestimmung des exponentiellen Störterms kann dieser genau kompensiert werden. A und B sind die zu bestimmenden Phasorkomponenten und können vorzugsweise wiederholt gemessen, gespeichert und gemittelt werden.

Die Bestimmung des Phasors kann über die richtige Wahl der Filterstufen beschleunigt werden, indem die Filterstufen der Filterkaskade so angeordnet sind, dass die erwartete Signalstärke des ausgefilterten Signalanteils entlang der Filterkaskade abnimmt. Die Phasorenbestimmung wird mit jedem Hinzufügen einer Filterstufe präziser, da so immer mehr störende Signalanteile des entsprechenden Vielfachen des Signals entfernt werden. Um das Verfahren schnell durchzuführen, können jedoch nicht beliebig viele Filterstufen hinzugefügt werden. Allerdings ist dieser störende Signalanteil je nach Vielfachem unterschiedlich groß, sodass einige Vielfache die Phasorenbestimmung stärker erschweren als andere. Werden nun vor dem Beginn der Phasorenbestimmung diejenigen Vielfachen ermittelt, deren Signalanteile den Ausgangswert am meisten stören und diese auch zuerst herausgefiltert, kann bereits mit wenigen Filterstufen eine zuverlässige Phasorenbestimmung durchgeführt werden. Um diese Vielfache und deren störende Signalanteile zu bestimmen und so die Abfolge der Filter zu optimieren, können beispielsweise die Pegel entsprechend der DIN IEC 61000-3-6 angenommen werden, wobei die gesamte harmonische Verzerrung (THD) ignoriert und von einem Rauschen von 1% ausgegangen wird. Danach kann für eine Reihe von vorbestimmten Harmonischen der Grundfrequenz überprüft werden welchen Einfluss das Ausfiltern der jeweiligen Harmonischen auf das ursprüngliche Signal hat und wie groß der Fehler des resultierenden Signals verglichen mit dem ursprünglichen Signal ist. Dabei kann zunächst jene vorbestimmte Harmonische bestimmt werden, die den geringsten Einfluss auf das resultierende Signal hat, wonach diese Harmonische abgespeichert und die Überprüfung für die verbleibenden vorbestimmten Harmonischen mit dem resultierenden Signal als ursprünglichen Signal solange iterativ fortgesetzt wird, bis eine gereihte Liste der vorbestimmten Harmonischen nach ihrem Einfluss auf das resultierende Signal vorliegt. Diese gereihte Liste kann dann für die Anordnung der Filterstufen herangezogen werden.

Um selbst bei einer Änderung der Netzfrequenz die Phasorenbestimmung fortführen zu können, ohne das Verfahren aufgrund verfälschter Werte abbrechen zu müssen, wird vorgeschlagen, dass in vorgegebenen Zeitschritten die Grundfrequenz des Strom- oder Spannungssignals bevorzugt automatisiert bestimmt und im Frequenzspeicher zur Anpassung der Filterstufen der Filterkaskade abgelegt wird. Neben der Grundfrequenz können die Frequenzen der Vielfachen ebenso im Frequenzspeicher abgespeichert werden, woraufhin die Filterstufen an die entsprechenden Vielfachen der bestimmten Grundfrequenz, ebenso bevorzugt automatisch, angepasst werden. Ändert sich die Grundfrequenz während der Phasorenbestimmung, kann diese Änderung erfasst und die jeweilige Filterstufe einfach an die neue Frequenz angepasst werden. Zufolge dieser Maßnahmen kann die korrekte Phasorenbestimmung insbesondere dann fortgeführt werden, wenn sich die Netzfrequenz ändert, ohne dass eine Abbruchbedingung erfolgen oder das bestimmte Phasorensignal auf seine Korrektheit überprüft werden muss. Obwohl in der Filterkaskade mehrere zeitlich aufeinanderfolgende Ausgangswerte einer Filterstufe in der nachfolgenden Filterstufe weiterverarbeitet werden, haben Versuche gezeigt, dass trotz einer Frequenzänderung der Grundfrequenz die zwischengespeicherten Ausgangswerte nicht verworfen werden müssen, sondern eine schrittweise Anpassung der Filterkaskade möglich ist. Dadurch kommt es selbst bei einer Frequenzänderung des Strom- oder Spannungssignals zu keiner Unterbrechung der Phasorbestimmung. Die geänderte Grundfrequenz wird vielmehr rasch durch den Phasor abgebildet, weil bereits die erste Filterstufe in einer bevorzugten Ausführungsform den erwarteten größten Signalanteil ausfiltert.

In der Zeichnung ist der Erfindungsgegenstand beispielsweise dargestellt. Es zeigen

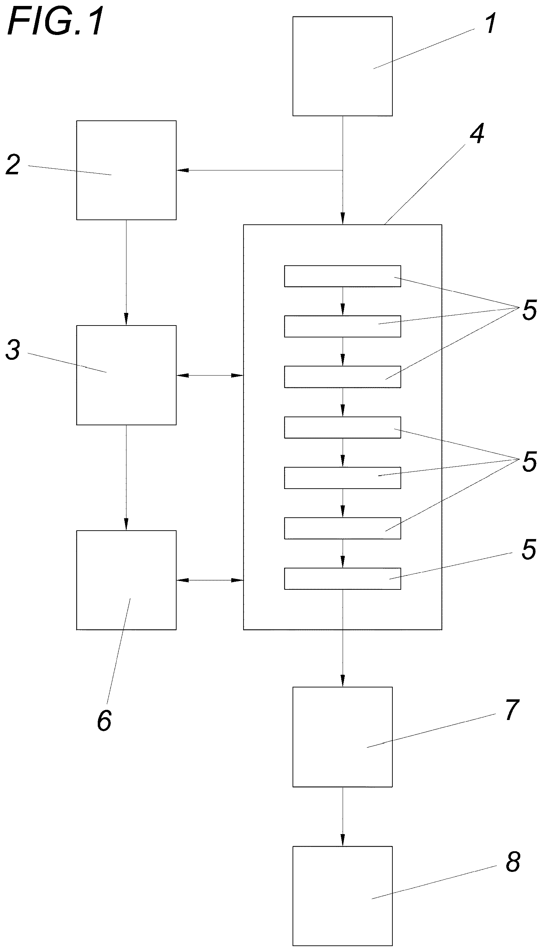

Fig. 1 eine schematische Darstellung einer Vorrichtung zur Durchführung des erfindungsgemäßen Verfahrens,

Fig. 2 den Amplitudengang einer erfindungsgemäßen Filterkaskade mit 7 Filterstufen bei einer Grundfrequenz von 50Hz und einer Abtastrate von 1000Hz,

Fig. 3 der Stromverlauf in einem beispielsweisen Kurzschlussfall, wobei die durchgezogene Linie den zeitlichen Verlauf der Messwerte und die gestrichelte Linie den zeitlichen Verlauf der Phasorwerte über die Zeit repräsentieren und

Fig. 4 der zeitliche Verlauf des root-mean-square-Wertes (RMS) des Phasors beim in der Fig. 3 gezeigten Kurzschlussfall.

Bei einer Vorrichtung zur Durchführung des erfindungsgemäßen Verfahrens wird das Strom- oder Spannungssignal zuerst in einem Analog-Digital-Wandler 1 abgetastet und aus dem Strom- oder Spannungssignal zeitlich diskrete Abtastwerte gebildet, die in der gezeigten Ausführungsform einem Frequenzmessgerät 2 zugeführt werden, um die Grundfrequenz zu bestimmen. Diese Frequenzmessung kann einmal zu Beginn des Verfahrens durchgeführt werden. Um das erfindungsgemäße Verfahren allerdings auch dann durchführen zu können, wenn sich die Grundfrequenz ändert, kann in bevorzugter Weise die Frequenz wiederholt bestimmt werden, um diese Änderung der Grundfrequenz in der Signalbearbeitung berücksichtigen zu können. Die mit dem Frequenzmessgerät 2 ermittelte Grundfrequenz kann anschließend in einem Frequenzspeicher 3 abgelegt werden. In diesem Frequenzspeicher 3 können auch die Vielfachen der Grundfrequenz bestimmt und diese mit der Grundfrequenz an die Filterkaskade 4 übergeben werden. Wird die Grundfrequenz nicht mit einem Frequenzmessgerät 2 bestimmt, kann diese direkt in dem Frequenzspeicher 3 abgelegt werden. Die Abtastwerte werden einer Filterkaskade 4 übergeben, die im gezeigten Beispiel aus sieben Filterstufen 5 besteht. Jede der Filterstufen 5 filtert den Signalanteil eines Vielfachen der Grundfrequenz aus, wobei diese Vielfache bevorzugt positive ganzzahlige Vielfache der Grundfrequenz, also Harmonische sind. In einer bevorzugten Ausführungsform wird vor der Durchführung des Verfahrens für mehrere Vielfache der Grundfrequenz die an der resultierenden Frequenz zu erwartende Signalstärke bestimmt und die verschiedenen Filterstufen 5 so angeordnet, dass die erwartete Signalstärke des ausgefilterten Signalanteils entlang der Filterkaskade 4 abnimmt. Dadurch können die Signalanteile, die die Bestimmung des Phasors am meisten beeinträchtigen, zuerst herausgefiltert werden. Die zumindest teilweise gefilterten Abtastwerte können nach dem Durchlaufen einer oder mehrerer Filterstufen 5 in einem Signalspeicher 6 zwischengespeichert und von nachfolgenden Filterstufen 5 abgerufen werden. Optional können die zwischengespeicherten Abtastwerte auch vor der Weiterverarbeitung gemittelt werden. Anschließend werden die gefilterten Abtastwerte von der Filterkaskade 4 entweder direkt aus den Filterstufen 5 oder aus dem Signalspeicher 6 an eine Recheneinheit 7 übergeben, die den Phasor bestimmt und in einem folgenden Schritt über ein Ausgabegerät 8 ausgibt.

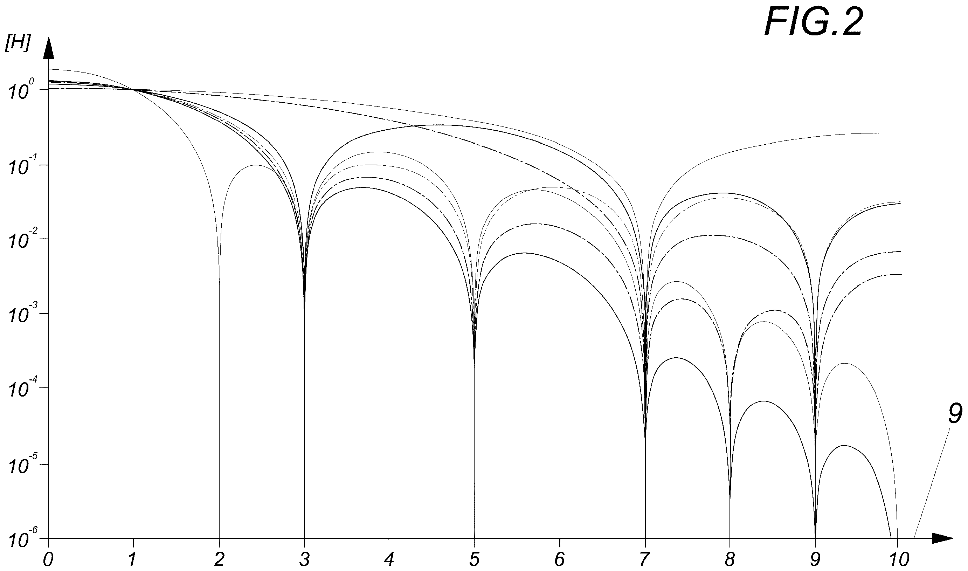

Die Wirkungsweise und Reihung der Filterstufen 5 kann dem frequenzabhängigen Amplitudengang der Fig. 2 für eine Filterkaskade 4 bestehend aus sieben Filtern entnommen werden. Die einzelnen Amplitudengänge der Fig. 2 entsprechen dabei dem resultierenden Amplitudengang der Filterkaskade 4 bei einer unterschiedlichen Anzahl von Filterstufen 5. Auf der X-Achse 9 sind die Vielfachen der Grundfrequenz aufgetragen. Die Reihung der Filterstufen 5 basiert dabei auf der vorab durchgeführten, oben beschriebenen Bestimmung derjenigen Signalanteile eines Vielfachen der Grundfrequenz, die den Ausgangswert am meisten stören. Demzufolge filtert die erste Filterstufe den Signalanteil der siebten Harmonischen, die zweite Filterstufe filtert die neunte Harmonische usw..

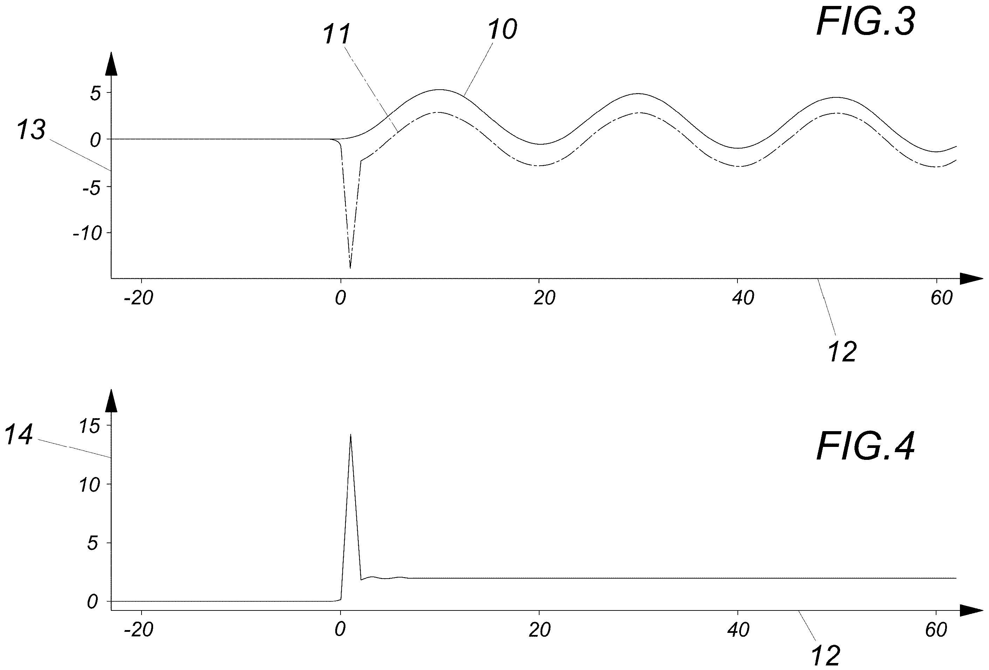

Fig. 3 zeigt das gemessene Stromsignal 10 und den durch die oben beschriebenen Phasorkomponenten A und B bestimmten Phasor 11, wobei auf der x-Achse 12 die Zeit in Millisekunden und auf der y-Achse 13 die Stromstärke in Ampere aufgetragen ist. Zum Zeitpunkt 0 löst ein Kurzschluss einen transienten Einschwingvorgang aus. Durch einen Sprungdetektor wird unmittelbar nach dem Zeitpunkt 0 eine starke Signaländerung detektiert und daraufhin die erfindungsgemäße Filterkaskade 4 zurückgesetzt. Da die einzelnen Filterstufen 5 nicht nur von den Momentanwerten, sondern auch von zeitlich vorangegangenen Eingangswerten abhängen, sind zunächst die ersten Filterstufen 5 unbestimmt, sodass eine valide Phasorbestimmung noch nicht möglich ist. Liegen alle erforderlichen Eingangswerte für die erste Filterstufe vor und sind ausreichend Ausgangswerte der ersten Filterstufe zur Phasorbestimmung vorhanden, so können diese Ausgangswerte für die Phasorbestimmung herangezogen werden. Somit liegt bereits wenige Millisekunden nach dem Zeitpunkt 0 ein bestimmter Phasor vor. Mit zunehmender Anzahl aktiver Filterstufen 5 verbessert sich die Phasorbestimmung, wie insbesondere der Fig. 4 entnommen werden kann. Der Gleichstromanteil des Signals klingt einer Exponentialfunktion folgend ab, wie der Schwingung des gemessenen Stromsignals 10 und dem Phasor 11 der Fig. 3 entnommen werden kann. Dieser Gleichstromanteil bzw. Offset hängt von den Reaktanzen im Netz ab. Der Phasor folgt dieser Schwingung der Messwerte wobei die Verschiebung zwischen Phasor und Messwerte entlang der y-Achse 13 auf den abklingenden Gleichstromanteil zurückzuführen ist. Im Gegensatz zu aus dem Stand der Technik bekannten Verfahren zur Phasorbestimmung bleibt der RMS des Phasors, dessen Wert auf der der auf der y-Achse 14 der Fig. 4 aufgetragen ist, trotz des abklingenden Gleichstromanteils nach der Aktivierung aller Filterstufen 5 konstant und der bestimmte Phasor ist bereits nach wenigen Millisekunden aufgrund der erfindungsgemäßen Reihung der Filterstufen 5 mit einem äußerst geringen Fehler behaftet.

**Patentansprüche**

1. Verfahren zur Phasorbestimmung eines Strom- oder Spannungssignals wobei das Strom- oder Spannungssignal abgetastet wird und die zeitlich diskreten Abtastwerte einer mehrstufigen Filterkaskade (4) zugeführt werden, wonach aus den in den Frequenzbereich transformierten, gefilterten Abtastwerten die Parameter des Phasors bestimmt und ausgegeben werden, wobei die Filterkaskade (4) mehrere Filterstufen (5) umfasst, wobei in jeder Filterstufe (5) ein Signalanteil mit einem vorgegebenen Vielfachen einer in einem Frequenzspeicher (3) abgespeicherten Grundfrequenz aus den Abtastwerten ausgefiltert und dazu aufeinanderfolgende Eingangswerte zur Bestimmung eines Ausgangswerts zwischengespeichert werden.

2. Verfahren nach Anspruch 1, **dadurch gekennzeichnet, dass** die Filterstufen (5) der Filterkaskade (4) so angeordnet sind, dass die erwartete Signalstärke des ausgefilterten Signalanteils entlang der Filterkaskade (4) abnimmt.

3. Verfahren nach Anspruch 1 oder 2, **dadurch gekennzeichnet, dass** in vorgegebenen Zeitschritten die Grundfrequenz des Strom- oder Spannungssignals bestimmt und im Frequenzspeicher (3) zur Anpassung der Filterstufen (5) der Filterkaskade (4) abgelegt wird.

**Claims**

1. Method for determining the phasor of a current or voltage signal, wherein the current or voltage signal is sampled and the time-discrete samples are supplied to a multi-stage filter cascade (4), after which from the filtered samples transformed into the frequency domain the parameters of the phasor are determined and output, wherein the filter cascade (4) comprises a plurality of filter stages (5), wherein in each filter stage (5) a signal component having a predetermined multiple of a fundamental frequency stored in a frequency memory (3) is filtered out of the samples and successive input values are stored intermediately to determine an output value.

2. Method according to claim 1, **characterised in that** the filter stages (5) of the filter cascade (4) are arranged in such a way that the expected signal strength of the filtered signal component decreases along the filter cascade (4).

3. Method according to claim 1 or 2, **characterised in that** the fundamental frequency of the current or voltage signal is determined in predetermined time steps and stored in the frequency memory (3) for the purpose of adjusting the filter stages (5) of the filter cascade (4).

**Revendications**

1. Procédé destiné à déterminer la phase d'un signal de courant ou de tension, dans lequel le signal de courant ou de tension est échantillonné et les valeurs d'échantillonnage discrètes dans le temps sont transmises à une cascade de filtres (4) à plusieurs étages, après quoi les paramètres du phaseur sont déterminés et distribués à partir des valeurs d'échantillonnage filtrées transformées dans la plage de fréquences, dans lequel la cascade de filtres (4) comprend plusieurs étages de filtres (5), dans lequel dans chaque étage de filtre (5) une composante de signal avec un multiple prédéfini d'une fréquence fondamentale enregistrée dans une mémoire de fréquences (3) est filtrée à partir des valeurs d'échantillonnage et des valeurs d'entrée successives sont donc enregistrées temporairement pour déterminer une valeur de sortie.

2. Procédé selon la revendication 1, **caractérisé en ce que** les étages de filtres (5) de la cascade de filtres (4) sont disposés de telle sorte que l'intensité de signal attendue de la composante de signal filtrée diminue le long de la cascade de filtres (4).

3. Procédé selon la revendication 1 ou 2, **caractérisé en ce que** la fréquence fondamentale du signal de courant ou de tension est déterminée dans des périodes de temps prédéfinies et déposée dans la mémoire de fréquences (3) pour adapter les étages de filtres (5) de la cascade de filtres (4).

*FIG.1*

FIG.2

*FIG.3*

*FIG.4*

EP 4 187 263 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- P-Class Phasor Measurement Unit algorithms using adaptive filtering to enhance accuracy at off-nominal frequencies. **ANDREW J ROSCOE et al.** SMART MEASUREMENTS FOR FUTURE GRIDS (SMFG), 2011 IEEE INTERNATIONAL CONFERENCE. IEEE, 14 November 2011, 51-58